Europäisches Patentamt

European Patent Office

Office européen des brevets

(19)

(11) **EP 0 902 539 A1**

(12) **EUROPÄISCHE PATENTANMELDUNG**

(43) Veröffentlichungstag:
17.03.1999 Patentblatt 1999/11

(51) Int. Cl.$^6$: **H03K 19/00**

(21) Anmeldenummer: 98115648.2

(22) Anmeldetag: 19.08.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 10.09.1997 DE 19739806

(71) Anmelder:
SIEMENS AKTIENGESELLSCHAFT
80333 München (DE)

(72) Erfinder:
• Schneider, Ralf
81925 München (DE)
• Manyoki, Zoltan
81739 München (DE)
• Wirth, Norbert
85716 Unterschleissheim (DE)

(54) **Eingangsschaltung mit steuerbarer Schaltwelle**

(57) Eingangsschaltung mit

einer durch eine Referenzspannung (Ref) gesteuerten Spannungsquelle (3 bis 6) zur Abgabe einer Spannung (V), die gleich dem n-fachen Referenzpotential (Ref) ist, und

einer einen Signaleingang (E) und einen Signalausgang (A) aufweisenden Pufferschaltung (1, 2), die durch die gesteuerte Spannungsquelle (3 bis 6) versorgt wird.

**Beschreibung**

Die Erfindung betrifft eine Eingangsschaltung.

Insbesondere bei integrierten digitalen Schaltkreisen ist es des öfteren notwendig, den Eingangssignalpegel und damit die Schaltschwelle an ein extern zugeführtes Eingangssignal anzupassen. Zu diesem Zweck werden häufig Eingangsschaltung mit steuerbarer Schaltschwelle verwendet. Derartige Eingangsschaltung werden meist als Differenzverstärkerschaltung ausgeführt, bei der an einen Eingang das Eingangssignal und an den anderen Eingang ein veränderbares Referenzpotential zur Steuerung der Schaltschwelle angelegt ist. Nachteil dabei ist, daß durch die Differenzverstärkerschaltung ein statischer Strom fließt, der beispielsweise bei Verwendung mehrerer derartiger Eingangsschaltung zu einer erheblichen Mindeststromaufnahme der integrierten Schaltung führt.

Aufgabe der Erfindung ist es daher, eine Eingangsschaltung mit steuerbarer Eingangsschwelle anzugeben, bei der ein geringerer statischer Strom fließt.

Die Aufgabe wird durch eine Eingangsschaltung gemäß Patentanspruch 1 gelöst. Ausgestaltungen und Weiterbildungen des Erfindungsgedankens sind Gegenstand von Unteransprüchen.

Erfindungsgemäß enthält eine Eingangsschaltung eine durch eine Referenzspannung gesteuerte Spannungsquelle zur Abgabe einer Spannung, die gleich dem n-fachen Referenzpotential ist, und eine einen Signaleingang und einen Signalausgang aufweisenden Pufferschaltung, die durch die gesteuerte Spannungsquelle versorgt wird.

Damit läßt sich durch Ändern der Referenzspannung die an der Pufferschaltung anliegende, zu deren Versorgung vorgesehene Spannung und demzufolge die Schwellenspannung der Pufferschaltung in beliebiger Weise einstellen. Die Pufferschaltung hat bevorzugt eine möglichst geringe oder keine statische Stromaufnahme. Als Pufferschaltung können dabei auch Logikschaltungen im allgemeinen und verschiedene Arten von Gatter im besonderen verwendet werden. Als gesteuerte Spannungsquellen finden insbesondere Verstärkerschaltungen oder steuerbare Spannungsregler Verwendung, die aufgrund des niederfrequenten Betriebs insgesamt eine geringe Stromaufnahme ermöglichen.

Bevorzugt ist eine Pufferschaltung mit einem ersten Transistor von einem ersten Leitungstyp und mit einem zweiten Transistor von einem zweiten Leitungstyp vorgesehen. Bei den beiden Transistoren sind die Steueranschlüsse jeweils miteinander verbunden und ihre gesteuerten Strecken sind in Reihe zueinander an die gesteuerte Spannungsquelle angeschlossen. Derartige Pufferschaltung zeichnen sich dadurch aus, daß sie nur einen geringen Schaltungsaufwand erfordern und praktisch keinen statischen Strom aufweisen.

Bei einer Weiterbildung der Erfindung ist n gleich dem Verhältnis der von der gesteuerten Spannungsquelle abgegebenen Spannung zur Schwellenspannung der Pufferschaltung. Dadurch wird erreicht, daß die Schwellenspannung gleich der Referenzspannung ist und damit auf einfache Weise die Schwellenspannung über die Referenzspannung beispielsweise von extern bestimmbar ist.

Schließlich kann mindestens eine weitere Pufferstufe an die gesteuerte Spannungsquelle angeschlossen werden. Der Vorteil dabei ist, daß die gesteuerte Spannungsquelle für mehrere Eingänge genutzt wird, so daß ihr Ruhestrombeitrag pro Eingang geringer ist.

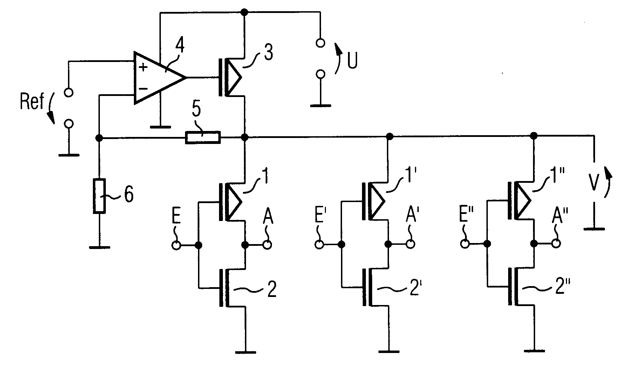

Die Erfindung wird nachfolgend anhand des in der einzigen Figur der Zeichnung dargestellten Ausführungsbeispiels naher erläutert.

Bei der in der Zeichnung gezeigten Ausführungsform ist eine Inverterschaltung mit zwei MOS-Feldeffekttransistoren 1 und 2 als Pufferschaltung vorgesehen. Dabei ist einer 1 der Transistoren 1, 2 vom p-Kanal-Typ und der andere 2 vom n-Kanal-Typ. Bei den Transistoren 1 und 2 sind jeweils die Gateanschlüsse miteinander sowie mit einem Eingang E verbunden. Die Drainanschlüsse beider Transistoren 1, 2 sind ebenfalls miteinander verbunden sowie zudem mit einem Ausgangsanschluß A gekoppelt. Der Sourceanschluß des Transistors 1 ist an den Ausgang einer gesteuerten Spannungsquelle angeschlossen, die eine Spannung V abgibt.

Die gesteuerte Spannungsquelle wird durch einen weiteren MOS-Feldeffekttransistor 3 vom p-Kanaltyp gebildet. Beim Transistor 3 ist der Sourceanschluß an den positiven Pol einer Versorgungsspannung U angeschlossen und der Drainanschluß mit dem Sourceanschluß des Transistors 1 verbunden. Der Sourceanschluß des Transistors 2 der Pufferstufe ist dabei an den negativen Pol der Versorgungsspannung U angeschlossen.

Der Gateanschluß des Transistors 3 ist an den Ausgang eines Operationsverstärkers 4 mit geringer Stromaufnahme angeschlossen, der durch die Versorgungsspannung U gespeist wird. An dem nichtinvertierenden Eingang des Operationsverstärkers 4 ist die Referenzspannung Ref angelegt. Ein Verhältnis n, das gleich dem Verhältnis der Spannung V zur Referenzspannung Ref ist, wird durch entsprechende Dimensionierung eines Spannungsteilers eingestellt. Der Spannungsteiler besteht aus einem zwischen den Drainanschluß des Transistors 3 und den invertierenden Eingang des Operationsverstärkers 4 geschalteten Widerstand 5 sowie einen zwischen den Eingang des Operationsverstärkers 4 und den negativen Pol der Versorgungsspannung U geschalteten Widerstand 6. Für das Verhältnis n gilt:

$$n = 1+(R_5/R_6) = V/Ref \qquad (1)$$

Dabei ist $R_5$ der Wert des Widerstands 5 und $R_6$ der

Wert des Widerstands 6.

Beim vorliegenden Ausführungsbeispiel haben die Transistoren 1 und 2 im wesentlichen gleiche (zueinander symmetrische) Eigenschaften, so daß die Schwellenspannung S der Pufferstufe bei etwa der Hälfte der die Pufferstufe versorgenden Spannung V liegt. Folglich ist:

$$S = V/2 \qquad (2)$$

Damit die Referenzspannung Ref gleich der Schwellenspannung S wird, folgt aus (1) und (2):

$$Ref = S = V/n = V/2 \qquad (3)$$

und damit:

$$n = 2$$

Bei unsymmetrischer Auslegung der Transistoren 1 und 2 ist die Schwellenspannung entsprechend anders und damit ist auch das Verhältnis von Spannung V und Schwellenspannung S anders. Um dennoch zu erreichen, daß die Referenzspannung Ref gleich der Schwellenspannung S ist, muß n entsprechend n = V/S abgeändert werden.

Schließlich werden beim Ausführungsbeispiel zwei weitere, identische Pufferstufen mit der Spannung V versorgt. Jede der weiteren Pufferstufen enthält zwei MOS-Feldeffekttransistoren 1' und 2' bzw. 1" und 2", die in gleicherweise wie die Transistoren 1 und 2 mit einem dem Eingang E entsprechenden weiteren Eingang E' bzw. E" sowie einem dem Ausgang A entsprechendem weiteren Ausgang A' bzw. A" verbunden sind. Da die statische Stromaufnahme der Pufferstufen vernachlässigbar ist, wird die gesamte statische Stromaufnahme durch den geringen Ruhestrom der gesteuerten Stromquelle bestimmt.

**Patentansprüche**

1. Eingangsschaltung mit

   einer durch eine Referenzspannung (Ref) gesteuerten Spannungsquelle (3 bis 6) zur Abgabe einer Spannung (V), die gleich dem n-fachen Referenzpotential (Ref) ist, und
   einer einen Signaleingang (E) und einen Signalausgang (A) aufweisenden Pufferschaltung (1, 2), die durch die gesteuerte Spannungsquelle (3 bis 6) versorgt wird.

2. Eingangsschaltung nach Anspruch 1, bei der die Pufferschaltung (1, 2) einen ersten Transistor (1) von einem ersten Leitungstyp und einen zweiten Transistor (2) von einem zweiten Leitungstyp aufweist, deren Steueranschlüsse jeweils miteinander verbunden sind und deren gesteuerte Strecken in Reihe zueinander an die gesteuerte Spannungsquelle(3 bis 6) angeschlossen sind.

3. Eingangsschaltung nach Anspruch 1 oder 2, bei der n gleich dem Verhältnis der von der gesteuerten Spannungsquelle bereitgestellten Spannung zur Schwellenspannung der Pufferschaltung (1, 2) ist.

4. Eingangsschaltung nach Anspruch 1 oder 2, bei der mindestens eine weitere Pufferstufe (1', 2'; 1", 2") an die gesteuerte Spannungsquelle (3 bis 6) angeschlossen ist.

Europäisches
Patentamt

**EUROPÄISCHER RECHERCHENBERICHT**

Nummer der Anmeldung

EP 98 11 5648

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US 5 086 238 A (KAWAHARA TAKAYUKI ET AL) 4. Februar 1992 <br> * Spalte 6, Zeile 27 - Spalte 8, Zeile 29; Abbildungen 7A,7B * <br> * Spalte 14, Zeile 15 - Zeile 40; Abbildung 25 * <br> * Spalte 38, Zeile 30 - Zeile 39; Abbildung 63 * | 1-4 | H03K19/00 |
| A | US 4 430 582 A (BOSE BIDYUT K ET AL) 7. Februar 1984 <br> * das ganze Dokument * | 1-4 | |
| A | US 5 329 184 A (REDFERN THOMAS P) 12. Juli 1994 <br> * das ganze Dokument * | 1-4 | |
| A | EP 0 223 267 A (XILINX INC) 27. Mai 1987 <br> * Abbildung 2 * | 1-4 | |
| A | PATENT ABSTRACTS OF JAPAN vol. 008, no. 213 (E-269), 28. September 1984 <br> & JP 59 099817 A (SUWA SEIKOSHA KK), 8. Juni 1984 <br> * Zusammenfassung * | 1-4 | RECHERCHIERTE SACHGEBIETE (Int.Cl.6) <br><br> H03K |
| A | PATENT ABSTRACTS OF JAPAN vol. 017, no. 570 (E-1448), 15. Oktober 1993 <br> & JP 05 167430 A (NEC CORP), 2. Juli 1993 <br> * Zusammenfassung * | 1-4 | |

Der vorliegende Recherchenbericht wurde für alle Patentansprüche erstellt

| Recherchenort | Abschlußdatum der Recherche | Prüfer |
|---|---|---|
| DEN HAAG | 18. Dezember 1998 | Feuer, F |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 98 11 5648

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-12-1998

| Im Recherchenbericht angeführtes Patentdokument | Datum der Veröffentlichung | Mitglied(er) der Patentfamilie | | Datum der Veröffentlichung |
|---|---|---|---|---|
| US 5086238 A | 04-02-1992 | JP | 2753218 B | 18-05-1998 |
| | | JP | 62178013 A | 05-08-1987 |
| | | JP | 62189816 A | 19-08-1987 |
| | | JP | 2072235 C | 25-07-1996 |
| | | JP | 7111825 B | 29-11-1995 |
| | | JP | 62021323 A | 29-01-1987 |
| | | DE | 3688222 A | 13-05-1993 |
| | | DE | 3688222 T | 04-11-1993 |
| | | EP | 0209805 A | 28-01-1987 |
| | | EP | 0433271 A | 19-06-1991 |
| | | US | 4837462 A | 06-06-1989 |
| | | US | 4730132 A | 08-03-1988 |
| | | JP | 2000350 A | 05-01-1990 |
| | | JP | 2735221 B | 02-04-1998 |
| | | KR | 9703232 B | 15-03-1997 |
| | | US | 5822267 A | 13-10-1998 |
| | | US | 5197033 A | 23-03-1993 |
| | | US | 5396116 A | 07-03-1995 |
| | | US | 5377156 A | 27-12-1994 |
| US 4430582 A | 07-02-1984 | KEINE | | |
| US 5329184 A | 12-07-1994 | KEINE | | |
| EP 0223267 A | 27-05-1987 | US | 4820937 A | 11-04-1989 |
| | | CA | 1267196 A | 27-03-1990 |
| | | JP | 62142416 A | 25-06-1987 |

Für nähere Einzelheiten zu diesem Anhang : siehe Amtsblatt des Europäischen Patentamts, Nr. 12/82